# EUROPÄISCHE PATENTANMELDUNG

(11) **EP 2 933 849 A1**
(43) Veröffentlichungstag der Anmeldung: **21.10.2015**
(21) Anmeldenummer: 14164796.6
(22) Anmeldetag: 15.04.2014
(51) Int. Cl.: H01L 51/00

(54) **Hostmaterialien für OLEDs**

(71) Anmelder: cynora GmbH, 76646 Bruchsal (DE)
(72) Erfinder: VOLZ, Daniel, 76137 Karlsruhe (DE)
(74) Vertreter: Hoppe, Georg Johannes

(57) **Zusammenfassung**

Die Erfindung betrifft Matrixmaterialien für OLEDs. Die Matrixmaterialien weisen eine Struktur der Formel 1 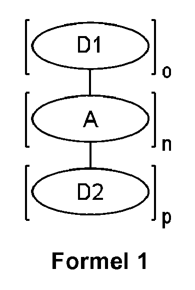 auf. A ist eine Akzeptorgruppe mit elektronenziehenden Eigenschaften und D1 und D2 sind Donorgruppen mit elektronenschiebenden Eigenschaften.

## Beschreibung

Die Erfindung betrifft Moleküle der allgemeinen Formel 1, und deren Verwendung als Hostmaterialien in OLEDs (organic light emitting diodes) und anderen opto-elektronischen Bauelementen.

### Einleitung

Die auf OLED (Organic Light Emitting Diodes) basierende Technologie hat sich in den letzten Jahren im Bereich von Beleuchtungs- und Displayapplikationen als kostengünstige und energieeffiziente Technik durchgesetzt. Entsprechende Produkte sind bereits heute kommerziell erhältlich und werden in verschiedensten Arten von opto-elektronischen Bauelementen eingesetzt.

In der Regel sind derartige Bauteile in Schichtstrukturen realisiert, welche überwiegend aus organischen Materialien bestehen. Zum besseren Verständnis ist in Figuren

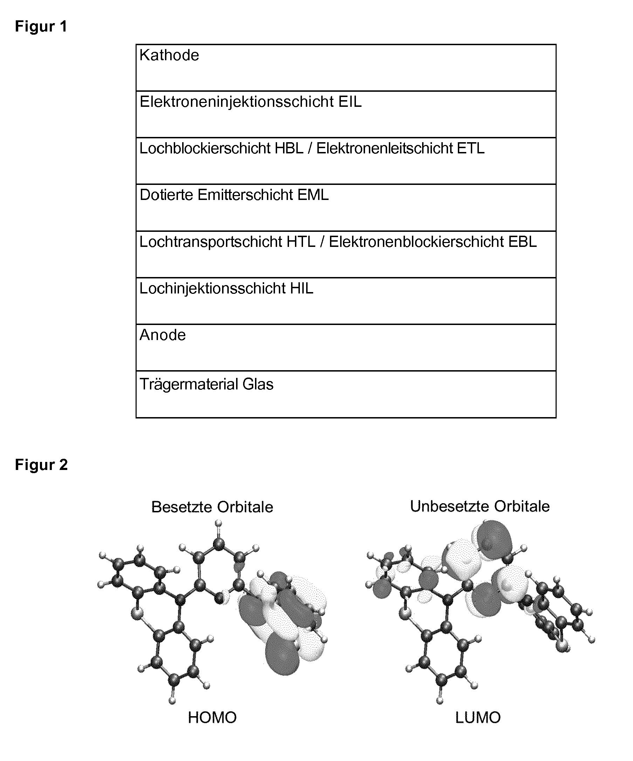

Figur 1 ein vereinfachter Aufbau exemplarisch dargestellt. Herzstück solcher Bauteile ist die Emitterschicht, welche typischerweise zwischen einer Anode und einer Kathode angeordnet ist und die in der Regel aus einem Hostmaterial besteht, in welches die emittierenden Moleküle eingebettet sind. Weitere Schichten, wie die Lochinjektionsschicht, die Lochtransportschicht, die Elektronenleitschicht und die Zwischenschicht bewirken im Allgemeinen eine dramatisch verbesserte Effizienz der Bauteile. Bei Anlegen eines Stroms/einer Spannung treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Alle Materialien eines opto-elektronischen Bauelements müssen so gewählt werden, dass eine optimale Injektion der Ladungen (Löcher und Elektronen) von den Elektroden und Ausbildung der Exzitonen in der Emitterschicht ermöglicht wird. Die Entwicklung effektiver Hostmaterialien ist für die Produktion effizienter opto-elektronischer Bauelemente hierbei genau so wichtig wie die Entwicklung neuer Emittermaterialien.

Hostmaterialien müssen eine effiziente Energieniveau-Nivellierung ermöglichen, um die Energieniveaus der verwendeten Elektroden stufenweisen an die Energieniveaus der Emittermoleküle anzupassen. Weiterhin sollten die verwendeten Hostmaterialien idealerweise einen ausgeglichenen Ladungstransport (eine Ladungsträgerbalance von positiven und negativen Ladungsträgern) gewährleisten. Gängige Hostmaterialien, wie CBP, mCP, TPBi und TCTA sind jedoch nur in der Lage entweder bevorzugt Löcher oder bevorzugt Elektronen zu transportieren. Beim Einsatz solcher unipolaren Materialien findet die Ladungsträgerrekombination und Bildung der Exzitonen meist nahe der Grenzfläche zur Ladungstransport-Schicht statt. Diese räumliche Beschränkung kann bei wachsender Helligkeit oder Stromdichte zu einer Effizienz-Abnahme der optoelektronischen Bauteile ("roll-off") führen. Durch die schmale Rekombinationszone trägt außerdem nur ein geringer Teil der Moleküle zum Ladungstransport, zur Exzitonbildung und schließlich zur Lichtemission bei, wodurch das Bauteil keine optimale Betriebsdauer erreichen kann. Dieses Problem kann durch den Einsatz von ambipolaren Hosts für OLEDs in der Emissionsschicht umgangen werden. Dabei werden zum einen Donor- und Akzeptormoleküle als Mischungen eingesetzt (K. Goushi, K. Yoshida, K. Sato, C. Adachi, Nat. Photonics 2012, 6, 253-258), welche die Effizienz der Bauteile vor allem bei hohen Stromdichten nachhaltig verbessern. Allerdings führen die benötigten hohen Konzentrationen des zusätzlichen Ladungstransportmaterials häufig zu Phasentrennungen und dadurch zu Verschlechterungen der Langzeitstabilitäten der optoelektronischen Bauteile. Geeigneter sind hier sogenannte ambipolare Materialien, bei denen beide Funktionalitäten von ein und demselben Molekül erfüllt werden (D. Wagner, S. T. Hoffmann, U. Heinemeyer, I. Münster, A. Köhler, P. Strohriegl, Chem. Mater. 2013**;** M. Ananth Reddy, A. Thomas, G. Mallesham, B. Sridhar, V. Jayathirtha Rao, K. Bhanuprakash, Tetrahedron Lett. 2011, 52, 6942-6947; S. O. Jeon, J. Y. Lee, J. Mater. Chem. 2012, 22, 7239; T.-H. Kwon, M. K. Kim, J. Kwon, D.-Y. Shin, S. J. Park, C.-L. Lee, J.-J. Kim, J.-I. Hong, Chem. Mater. 2007, 19, 3673-3680; N. Lin, J. Qiao, L. Duan, H. Li, L. Wang, Y. Qiu, J. Phys. Chem. C 2012, 116, 19451-19457; F. May, M. Al-Helwi, B. Baumeier, W. Kowalsky, E. Fuchs, C. Lennartz, D. Andrienko, J. Am. Chem. Soc. 2012, 134, 13818-22; D. C. Müller, T. Braig, H. G. Nothofer, M. Arnoldi, M. Gross, U. Scherf, O. Nuyken, K. Meerholz, ChemPhysChem 2000, 1, 207-11; A. Wada, T. Yasuda, Q. Zhang, Y. S. Yang, I. Takasu, S. Enomoto, C. Adachi, J. Mater. Chem. C 2013, 1, 2404; WO2010085676; WO2010136109; WO2014011483). Als lochtransportierende Einheiten (Donoren) der ambipolaren Moleküle werden vor allem Diarylamine oder Carbazol-Strukturen verwendet. Die hiermit hergestellten optoelektronischen Bauteile zeigen jedoch häufig Stabilitätsprobleme bzw. es ist eine geringe Langzeitstabilität festzustellen. Dies kann auf bekannte Degradationsmechanismen zurückgeführt werden, die auf der Abspaltung von Resten bei Diarylamin-Gruppen oder der Oligomerisierung/Knüpfung neuer Bindungen bei Verwendung von Carbazol-Gruppen beruhen. Die Eigenschaften der Bauteile werden durch diese Prozesse derart verändert, dass sich ihre Energieniveaus verschieben und es mittelfristig zu einer Zerstörung des Bauteils kommt. Durch Absättigung der reaktiven Positionen der lochtransportierenden Einheiten, z. B. durch tert-Butylgruppen, wurde versucht, dieses Problem zu umgehen (F. So, D. Kondakov, Ad. Mater. 2010, 22, 3762-3777). Allerdings hat dieses Vorgehen wiederrum den Nachteil, dass sich zum einen Parameter wie die Ladungsträgermobilität negativ verändern, was zu Morphologie-Problemen, insbesondere Phasenseparation also z.B. dem Auskristallisieren der Hostmaterialien und/oder der darin enthaltenen Emittermoleküle führen kann. Zum anderen können auch diese Schutzgruppen im Langzeitbetrieb der Bauteile abgespalten werden, was zu den eben beschriebenen Problemen führt.

Die Aufgabe der vorliegenden Erfindung besteht somit in der Bereitstellung neuer ambipolarer Hostmaterialien mit verbesserten Eigenschaften.

### Beschreibung

Es wurde überraschend gefunden, dass optoelektronische Bauelemente, die organische Moleküle gemäß nachstehender Formel (1) enthalten, deutliche Verbesserungen gegenüber dem Stand der Technik aufweisen, insbesondere beim Einsatz als Matrixmaterialien für lumineszierende Emitter, aber auch bei Verwendung als Elektronentransportmaterial oder als Lochinjektionsmaterial oder als Lochblockiermaterial.

Die erfindungsgemäßen organischen Moleküle umfassen mindestens eine Akzeptoreinheit, also eine Einheit mit elektronenziehenden Eigenschaften, an die bis zu fünf, bevorzugt bis zu vier, besonders bevorzugt bis zu zwei Donoreinheiten, also Einheiten mit elektronenschiebenden Eigenschaften, kovalent gebunden sind. Bei den Donoreinheiten handelt es sich um sechs- oder fünfgliedrige Ringsysteme, wobei mindestens eine Donoreinheit sechsgliedrig sein muss. Je nach Akzeptoreinheit können an diese bis zu fünf weitere Akzeptoreinheiten kovalent gebunden sein.

Die Erfindung stellt organische Moleküle der allgemeinen Formel 1 bereit, 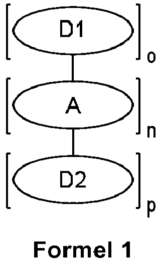 mit

A = eine Akzeptorgruppe mit elektronenziehenden Eigenschaften unabhängig voneinander ausgewählt aus der Gruppe aus Pyridin, Triazin, Pyrimidin, P(=O)R¹₂, P(=O)R¹, P(=S)R¹₂, P(=S)R¹, P(=Se)R¹₂, P(=Se)R¹, Benzimidazol, 1,2,4-oxadiazol, 1,2,4-triazol, oder 1,2,3-Triazol;
wobei gilt
R¹ ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch);
R² ist bei jedem Auftreten gleich oder verschieden Wasserstoff, Deuterium, Alkyl- (auch verzweigt oder zyklisch), Heteroalkyl-, Aryl-, Heteroaryl-, Alkenyl-, Alkinyl-Gruppen oder substituierte Alkyl- (auch verzweigt oder zyklisch), Heteroalkyl-, Aryl-, Heteroaryl- und Alkenyl-Gruppen mit Substituenten wie Halogene oder Deuterium, Alkylgruppen (auch verzweigt oder zyklisch);
und

D1 = eine Donorgruppe mit elektronenschiebenden Eigenschaften, aufweisend eine Struktur der Formel 1a; 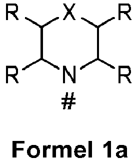 D2 = eine Donorgruppe mit elektronenschiebenden Eigenschaften, aufweisend eine Struktur der Formel 1b; 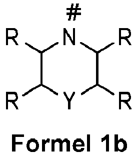 wobei für die verwendeten Symbole und Indizes gilt:
- n: ist eine ganze Zahl zwischen 0 und 5;
- o: ist eine ganze Zahl zwischen 1 und 5;
- p: eine ganze Zahl zwischen 0 und 5;
- X: ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- Y: ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
- R: ist bei jedem Auftreten gleich oder verschieden Wasserstoff, Deuterium, Halogen, eine Alkylgruppe (auch verzweigt oder zyklisch), eine Alkoxygruppe (auch verzweigt oder zyklisch), eine Alkenylgruppe (auch verzweigt oder zyklisch), oder eine Aryl- oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme; dabei können zwei oder mehrere Substituenten R auch miteinander, zusammen mit den Atomen, an die sie gebunden sind, ein mono- oder polycylisches aliphatisches oder aromatisches Ringsystem bilden;
- R³: ist bei jedem Auftreten gleich oder verschieden H, D, OR⁵, SR⁵ oder C(R⁵)₃;
- R⁴: ist bei jedem Auftreten gleich oder verschieden H, D, OR⁵, SR⁵ oder C(R⁵)₃;
- R⁵: ist bei jedem Auftreten gleich oder verschieden Wasserstoff, eine Alkylgruppe oder eine Arylgruppe;
und wobei die Verknüpfung mit A jeweils an der mit # gekennzeichneten Stelle in Form einer Einfachbindung stattfindet.

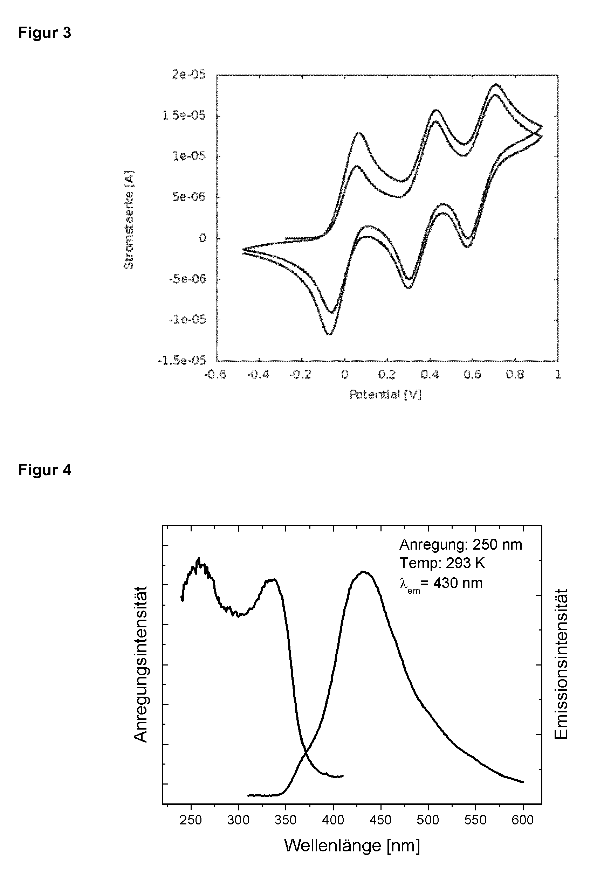

Die Strukturen der ambipolaren organischen Moleküle gemäß Formel 1 weisen, im Vergleich zu offenen Diarylsystemen bzw. Carbazol-artigen Systemen bei denen zentrale Fünfringe verwendet werden, eine erhöhte chemische und elektrochemische Stabilität auf. So werden die beiden in Diarylaminen verwendeten Arylreste miteinander verknüpft und ihre Abspaltung wird verhindert. Im Vergleich zu Materialien, die ausschließlich fünfgliedrige Ringsysteme enthalten, wird die Anzahl der reaktiven Positionen verringert bzw. bei ausschließlicher Verwendung von sechsgliedrigen Ringsystemen sogar komplett eliminiert. Die elektrochemische Stabilität verbessert sich vor allem durch die veränderten elektronischen Zustände. Das HOMO (highest occupied molecule orbital) von ambipolaren Molekülen ist auf der Donoreinheit lokalisiert, während das LUMO (lowest unoccupied molecule orbital) sich auf der Akzeptoreinheit befindet. So sitzt das HOMO bei literaturbekannten Verbindungen bevorzugt auf dem Fünfring. Dadurch wird der Zerfall solcher Moleküle begünstigt. Bei Vorhandensein eines Sechsrings liegt das HOMO aufgrund der niedrigeren Energie von beispielswesie Phenoxazin und Phenothiazin gegenüber Carbazol eher auf diesem (Figur 2). Die erhöhte Stabilität konnte für die erfindungsgemäßen organischen Moleküle durch Cyclovoltammetrie-Experimente bestätigt werden (Figur 3). Der Zerfall wird unterdrückt.

Durch das optionale Vorhandensein von fünfgliedrigen Einheiten in den erfindungsgemäßen organischen Molekülen können deren bekannte positive Eigenschaften, wie die gute Stapelung im amorphen Festkörper oder der gute Ladungstransport im Bauteil, weiterhin ausgenutzt werden.

Die erfindungsgemäßen organischen Moleküle gemäß Formel 1 weisen zudem eine hohe Triplett-Energie auf. Diese ist vor allem für die Kombination mit blauen Emittern vorteilhaft. Verursacht wird diese Eigenschaft durch die direkte Bindung von Donor- und Akzeptoreinheiten. Bekannte Moleküle, bei denen die beiden Teile durch Brückeneinheiten miteinander verbunden sind, weisen deutlich geringere Triplett-Energien auf.

In einer Ausführungsform der Erfindung weist D1 eine Struktur der Formel 2a und/oder D2 eine Struktur der Formel 2b auf; 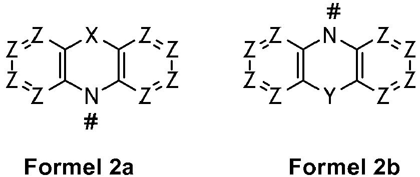 wobei gilt:
Z ist bei jedem Auftreten gleich oder verschieden N oder CR⁴ wobei zwei oder mehrere Substituenten R⁴ auch miteinander, zusammen mit den Atomen, an die sie gebunden sind, ein mono- oder polycylisches aliphatisches oder aromatisches Ringsystem bilden können;
und die weiteren Symbole die in Anspruch 1 angegebenen Bedeutungen haben.

In einem weiteren Aspekt betrifft die Erfindung ein Verfahren zur Herstellung eines hierin beschriebenen organischen Moleküls. Dieses erfindungsgemäße Verfahren weist den Schritt des Durchführens einer Reaktion von A mit D1 oder von A mit D1 und D2 auf,
mit
A = eine Akzeptorgruppe mit elektronenziehenden Eigenschaften;
D1 = eine Donorgruppe mit elektronenschiebenden Eigenschaften, aufweisend eine Struktur der Formel 1a; 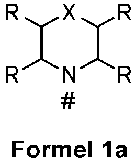 D2 = eine Donorgruppe mit elektronenschiebenden Eigenschaften, aufweisend eine Struktur der Formel 1b; 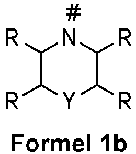 wobei die Verknüpfung mit A jeweils an der mit # gekennzeichneten Stelle in Form einer Einfachbindung stattfindet;
und wobei die weiteren Symbole die oben angegebenen Bedeutungen haben.

Die Reaktion wird bevorzugter Weise unter Zugabe einer starken Base durchgeführt. Zur Darstellung der Akzeptoreinheiten P(=O)R¹₂ oder P(=O)R¹ wird die Reaktion in einer weiteren Ausführungsform in bevorzugter Weise unter darauffolgender Zugabe eines Oxidationsmittels unabhängig voneinander ausgewählt aus der Gruppe aus Wasserstoffperoxid, Wasserstoffperoxid-Harnstoff-Addukt, Sauerstoff oder Ozon durchgeführt. Zur Darstellung der Akzeptoreinheiten P(=S)R¹₂, P(=S)R¹, P(=Se)R¹₂ oder P(=Se)R¹ erfolgt zudem die weitere Umsetzung mit Schwefel oder Lawessons Reagenz bzw. mit Selen.

Beispielhaft lassen sich folgende zwei allgemeine Syntheserouten formulieren:

### Variante 1:

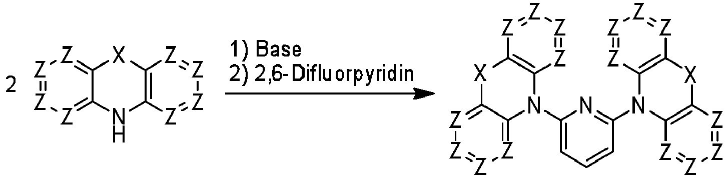

Dieses Verfahren kommt so oder in vergleichbarer Art zum Einsatz, wenn Pyridin, Triazin, Pyrimidin, Benzimidazol, 1,2,4-oxadiazol, 1,2,4-triazol, oder 1,2,3-Triazol als Akzeptoreinheit A gewählt werden. Dem Fachmann ist hierbei bekannt, welche Substituenten an der Akzeptoreinheit jeweils zur Umsetzung mit der Donoreinheit geeignet sind.

### Variante 2:

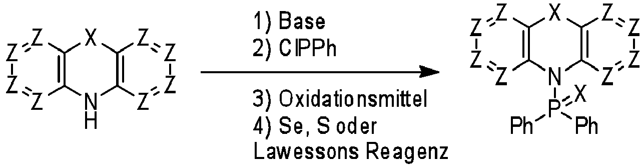

Dieses Verfahren kommt bis zu Schritt 3) zum Einsatz, wenn P(=O)R⁴₂ oder P(=O)R⁴ als Akzeptoreinheit A gewählt werden. Im Falle von P(=S)R⁴₂, P(=S)R⁴ bzw. P(=Se)R⁴₂, P(=Se)R⁴ werden alle vier Schritte durchgeführt. Dem Fachmann ist hierbei bekannt, welche Substituenten an der Akzeptoreinheit jeweils zur Umsetzung mit der Donoreinheit geeignet sind.

Ein weiterer Gegenstand der vorliegenden Verbindung ist die Verwendung eines organischen Moleküls der hierin beschriebenen Art in einer emittierenden Schicht als Matrixmaterial (Hostmaterial) für lumineszierende Emitter und/oder als Elektronentransportmaterial und/oder als Lochinjektionsmaterial und/oder als Lochblockiermaterial in einem optoelektronischen Bauelement.

In einer bevorzugten Ausführungsform der Erfindung wird das organische Molekül der hierin beschriebenen Art in einer emittierenden Schicht eines optoelektronischen Bauelementes, bevorzugt in Mischung mit mindestens einer weiteren Verbindung verwendet. Hierbei ist bevorzugt, dass das organische Molekül der hierin beschriebenen Art in der Mischung das Matrixmaterial ist.

In einer bevorzugten Ausführungsform der Erfindung wird ein organisches Moleküle der hierin beschriebenen Art entsprechend als Matrixmaterial für lumineszierende Emitter in einem optoelektronischen Bauelement eingesetzt.

Ein optoelektronisches Bauelement gemäß der vorliegenden Erfindung ist bevorzugt ausgewählt aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

Ein weiterer Erfindungsaspekt betrifft Mischungen, enthaltend mindestens ein organisches Molekül der hierin beschriebenen Art und mindestens einen lumineszierenden Emitter.

In einem weiteren Aspekt betrifft die Erfindung Formulierungen enthaltend mindestens ein organisches Molekül der hierin beschriebenen Art oder eine hier beschriebene Mischung und mindestens ein Lösemittel.

In einer Ausführungsform beträgt der Anteil des organischen Materials als Matrixmaterial in optischen lichtemittierenden Bauelementen, insbesondere in OLEDs, zwischen 50 % und 99 %.

In einem weiteren Aspekt betrifft die Erfindung ein optoelektronisches Bauelement aufweisend ein organisches Molekül der hierin beschriebenen Art. Hierbei enthält ein erfindungsgemäßes optoelektronisches Bauelement mindestens eine Schicht zwischen Anode und Kathode, die ein organisches Molekül der hierin beschriebenen Art beispielsweise als Matrixmaterial (Hostmaterial) für lumineszierende Emitter und/oder als Elektronentransportmaterial und/oder als Lochinjektionsmaterial und/oder als Lochblockiermaterial enthält. Hierbei kann das optoelektronische Bauelement ausgewählt sein aus der Gruppe bestehend aus organischem lichtemittierendem Bauelement, organischer Diode, organischer Solarzelle, organischem Transistor, organischer Licht-emittierender Diode, Licht-emittierender elektrochemischer Zelle, organischem Feldeffekttransistor und organischem Laser.

In einem weiteren Aspekt betrifft die Erfindung ein Verfahren zur Herstellung eines optoelektronischen Bauelements, wobei ein organisches Molekül der hierin beschriebenen Art verwendet wird.

Teil eines derartigen Verfahrens kann das Aufbringen eines erfindungsgemäßen organischen Moleküls auf einen Träger sein. Das Aufbringen kann optional durch Verdampfung im Vakuum oder nass-chemisch erfolgen.

Die hierfür gängigen Verfahren sind dem Fachmann bekannt und können von ihm ohne Probleme auf optoelektronische Bauelemente enthaltend ein organisches Molekül der hierin beschriebenen Art angewandt werden.

Die erfindungsgemäßen organischen Moleküle weisen bei Verwendung in optoelektronischen Bauteilen folgende überraschende Vorteile gegenüber dem Stand der Technik auf:
a. Die Ladungsträgermobilität im Bauteil wird verbessert im Vergleich zu Systemen gemäß dem Stand der Technik.
b. Die Effizienz der Bauteile ist höher im Vergleich zu Systemen gemäß dem Stand der Technik.
c. Die Stabilität der Bauteile ist höher im Vergleich zu Systemen gemäß dem Stand der Technik.
d. Die Lebensdauer der Bauteile ist höher im Vergleich zu Systemen gemäß dem Stand der Technik.

Im vorliegenden Anmeldetext und in den im Weiteren folgenden Beispielen wird in erster Linie auf die Verwendung der erfindungsgemäßen organischen Moleküle in OLEDs und den entsprechenden Displays und Beleuchtungselementen verwiesen. Trotzdem ist es dem Fachmann ohne erfinderisches Zutun möglich, die organischen Moleküle der hierin beschriebenen Art auch für weitere Verwendungen in anderen optoelektronischen Bauelementen einzusetzen.

Durch die nachfolgenden Beispiele wird die Erfindung näher erläutert, ohne sie dadurch einschränken zu wollen.

### Beispiele

### Beispiel 1: 2,6-Bis-(1-phenothiazinyl)-pyridin)

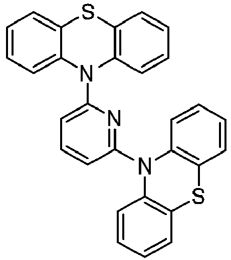

*2,6-Bis-N-phenothiazinoyl-pyridin.* 1H-Phenothiazin (12.00 g, 60 mmol, 2 Äquiv.) wurde zusammen mit Natriumhydrid (2.52 g, 63 mmol, 2.1 Äquiv) unter Stickstoff portionsweise mit insgesamt 200 mL Dioxan gelöst. Die Zugabegeschwindigkeit wurde dabei an die Wasserstoffbildung angepasst um ein Überschäumen zu vermeiden. Nach vollständiger Zugabe wurde die Reaktion für 15 min bei r.t. gerührt und anschließend für 15 min unter Rückfluss erhitzt. Dabei bildete sich eine klare, gelbe Lösung, die stark unter UV-Licht fluoresziert (366 nm Anregung). 2,6-Difluorpyridin (3.45 g, 30 mmol) wurde tropfenweise zur Reaktionsmischung zugegeben. Dabei schwächte sich die Fluoreszenz unter UV-Licht merklich ab. Die Reaktionsmischung wurde für 30 min weiter unter Rückfluss erhitzt, auf Raumtemperatur abkühlen lassen und durch tropfenweise Zugabe von 10 mL Wasser unter Stickstoff gequencht. Die Reaktionsmischung wurde in 800 mL gesättigte Natriumchloridlösung gegeben und das Rohprodukt durch Absaugen abgetrennt. Der so erhaltene Feststoff wurde mit 400 mL Wasser gewaschen und am Vakuum getrocknet. Das Produkt wurde zwei Mal sublimiert (260 °C, 5E-2 mbar) und anschließend aus Aceton umkristallisiert.

Farblose Kristalle (11.5 g, 81%). - ¹H NMR (500 MHz, Chloroform-d) δ 7.52 (dd, *J* = 8.0, 1.4 Hz, 4H), 7.43 (dd, *J* = 7.6, 1.6 Hz, 4H), 7.26 - 7.15 (m, 9H), 6.38 (d, *J* = 8.1 Hz, 2H) ppm. - ¹³C NMR (126 MHz, CDCl₃) δ 155.62, 141.48, 138.77, 133.54, 128.16, 127.99, 126.96, 125.45, 101.39 ppm. - IR (ATR) 3050 (vw), 1704 (m), 1594 (w), 1572 (s), 1561 (s), 1476 (m), 1457 (s), 1420 (vs), 1342 (s), 1295 (s), 1274 (m), 1252 (m), 1222 (m), 1194 (m), 1171 (m), 1122 (m), 1085 (w), 1030 (w), 751 (vs), 725 (vs), 632 (m), 616 (m), 544 (m), 529 (w), 460 (m) cm⁻¹. - C₂₉H₁₉N₃S₂ (473.61): ber. C 73.54, H 4.04, N 8.87 S 13.54 ; gef. C 73.79, H 4.10, N 8.87, S 13.79. E_{CV-HOMO} = -5.10 eV. E_{CV-LUMO} = -4.45 eV.

Die berechneten Grenzorbitale des Grundzustands sind in Figur 2 gezeigt.

Das Cyclovoltammogramm ist in Figur 3 gezeigt.

Das Anregungs- und Emissionsspektrum eines Films ist in Figur 4 gezeigt.

### Beispiel 2: Bis-N-phenothiazinenyl-phenyl-phosphinoxid

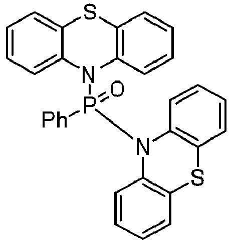

### Beispiel 3: 2,6-Bis-N-phenoxazinoyl-pyridin

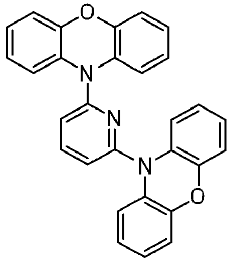

*2,6-Bis-N-phenoxazinoyl-pyridin.* Die Verbindung wurde analog zu Beispiel 1 aus 1H-Phenoxazin hergestellt. Die Ansatzgröße wurde dabei verdoppelt. Das Produkt wurde zwei Mal sublimiert (220 °C, 5E-2 mbar) und anschließend aus Aceton umkristallisiert. Gelbe Kristalle (81%). - ¹H NMR (500 MHz, Chloroform-d) δ = 7.78 (t, *J =* 7.9 Hz, 1 H), 7.19 (d, *J =* 7.9 Hz, 2H), 6.97 - 6.79 (m, 16H) ppm. - ¹³C NMR (126 MHz, Chloroform-d) δ = 154.9, 147.4, 141.0, 132.5, 123.7, 122.7, 118.7, 116.3, 115.4 ppm. - IR 2919 (vw), 1585 (m), 1558 (w), 1481 (s), 1435 (s), 1328 (s), 1292 (m), 1268 (vs), 1210 (s), 1153 (m), 1122 (m), 1041 (m), 993 (m), 922 (m), 863 (m), 844 (w), 741 (vs), 692 (m), 662 (m), 601 (w), 559 (vw), 449 (vw) 415 (vw) cm⁻¹. - FAB-MS (3-NBA) *m*/*z* (%): 441 [M⁺]. - HRMS C₂₉H₁₉O₂N₃: gef. 441.1474, ber. 441.1472.

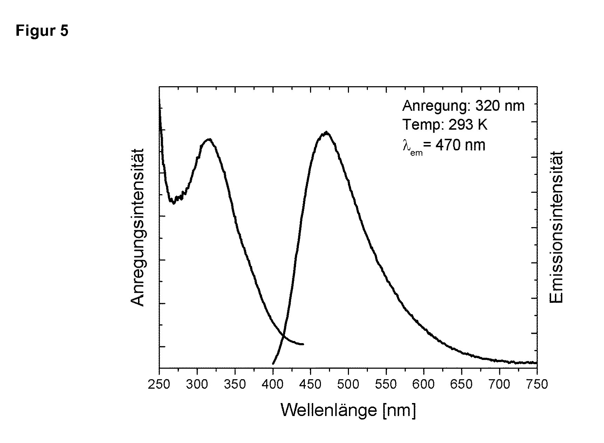

Das Anregungs- und Emissionsspektrum eines Films ist in Figur 5 gezeigt.

### Beispiel 4: Bis-N-phenoxazinenyl-phenyl-phosphinoxid

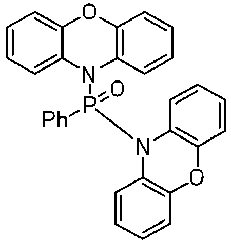

### Beispiel 5: 2-N-phenothiazinyl-6-N-(3, 6-bis-tBu-carbazoyl)-pyridin

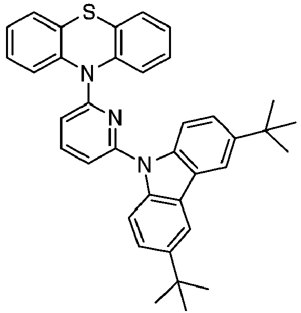

*2-N-phenothiazinyl-6-N-(3,6-bis-tBu-carbazoyl)-pyridin:* Die Verbindung kann durch stufenweise Substitution oder einer Eintopf-Substitution dargestellt werden.

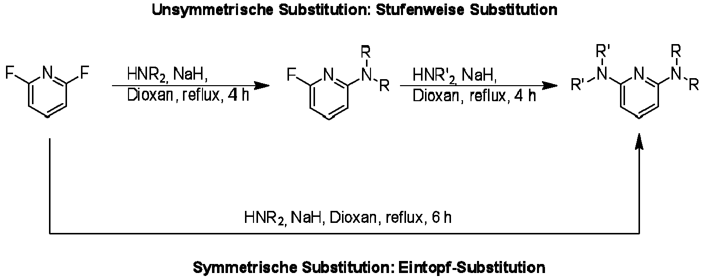

### Stufenweise Substitution: erster Substitutionsschritt:

Das Carbazolderivat (10 mmol, 1.00 Äquiv.) wird mit Natriumhydrid (60% mit Paraffin, 500 mg, 13 mmol, 1.3 Äquiv.) versetzt und unter Stickstoff portionsweise mit insgesamt 110 mL Dioxan gelöst. Die Zugabegeschwindigkeit wird dabei an die Wasserstoffbildung angepasst um ein Überschäumen zu vermeiden. Nach vollständiger Zugabe wurde die Reaktion für 15 min bei r.t. gerührt und anschließend für 15 min unter Rückfluss erhitzt. 2,6-Difluorpyridin (1.15 g, 10 mmol, 1.00 Äquiv.) wird tropfenweise zur Reaktionsmischung zugegeben. Dabei schwächt sich die Fluoreszenz unter UV-Licht merklich ab. Die Reaktionsmischung wird bis zu vollständigem Umsatz der Edukte (Reaktionskontrolle per HPLC, GC-MS oder DC; typischerweise 4 h) am Rückfluss erhitzt. Nach Abkühlen auf Raumtemperaturwird überschüssige Base durch tropfenweise Zugabe von 10 mL Wasser unter Stickstoff gequencht. Die Reaktionsmischung wurde in 200 mL gesättigte Natriumchloridlösung gegeben und das Rohprodukt durch Absaugen abgetrennt und mit Wasser (300 mL) sowie Methanol (60 mL) gewaschen. Der so erhaltene Feststoff wurde mit 200 mL heißem Toluol digeriert und der unlösliche Rückstand verworfen. Das Lösungsmittel wurde unter vermindertem Druck entfernt und das Produkt wurde mit Pentan (300 mL) und Diethylether (200 mL) gewaschen und am Vakuum getrocknet. Das Produkt wurde als beigefarbener Feststoff isoliert und in der Regel ohne weitere Aufreinigung weiter umgesetzt. Analysenreines Produkt konnte durch Vakuumsublimation bei 250 °C, 0.002 mbar beziehungsweise durch MPLC-Aufreinigung (Laufmittelgradient Cyclohexan - Dichlormethan) erhalten werden.

### Stufenweise Substitution: zweiter Substitutionssschritt:

Die Synthese, die Substitution mit 1H-Phenothiazin erfolgte analog zum ersten Schritt. Die Aufreinigung erfolgte mittels MPLC (Laufmittelgradient Cyclohexan - Dichlormethan).

### Eintopf-Synthese:

Das Carbazolderivat (20 mmol, 2.00 Äquiv.) wird mit Natriumhydrid (60% mit Paraffin, 1.00g, 26 mmol, 2.6 Äquiv.) versetzt und unter Stickstoff portionsweise mit insgesamt 250 mL Dioxan gelöst. Die Zugabegeschwindigkeit wird dabei an die Wasserstoffbildung angepasst um ein Überschäumen zu vermeiden. Nach vollständiger Zugabe wurde die Reaktion für 15 min bei r.t. gerührt und anschließend für 15 min unter Rückfluss erhitzt. 2,6-Difluorpyridin (1.15 g, 10 mmol, 1.00 Äquiv.) wird tropfenweise zur Reaktionsmischung zugegeben. Dabei schwächt sich die Fluoreszenz unter UV-Licht merklich ab. Die Reaktionsmischung wird bis zu vollständigem Umsatz der Edukte (Reaktionskontrolle per HPLC, GC-MS oder DC; typischerweise 6 h) am Rückfluss erhitzt. Nach Abkühlen auf Raumtemperatur wird überschüssige Base durch tropfenweise Zugabe von 10 mL Wasser unter Stickstoff gequencht. Die Reaktionsmischung wurde in 200 mL gesättigte Natriumchloridlösung gegeben und das Rohprodukt durch Absaugen abgetrennt und mit Wasser (300 mL) sowie Methanol (60 mL) gewaschen. Der so erhaltene Feststoff wurde mit 200 mL heißem Toluol digeriert und der unlösliche Rückstand verworfen. Das Lösungsmittel wurde unter vermindertem Druck entfernt und das Produkt wurde mit Pentan (300 mL) und Diethylether (200 mL) gewaschen und am Vakuum getrocknet. Zur Aufreinigung wurde das Produkt durch mehrfaches Umkristallisation bzw. in Einzelfällen durch Vakuumsublimation (Details siehe Einträge) aufgereinigt.

Beigefarbenes Pulver (87%). ¹H NMR (500 MHz, Chloroform-d) δ = 8.15 (d, *J* = 2.0 Hz, 2H), 7.79 (dd, *J* = 7.9, 1.4 Hz, 2H), 7.74 - 7.61 (m, 3H), 7.52 (dd, *J* = 7.7, 1.5 Hz, 2H), 7.41 (dd, *J* = 8.7, 2.0 Hz, 2H), 7.36 - 7.19 (m, 5H), 1.54 (s, 18H) ppm. - ¹³C NMR (126 MHz, Chloroform-d) δ = 156.7, 150.3, 143.6, 141.1, 139.6, 137.8, 133.5, 128.2, 128.1, 127.1, 126.0, 124.4, 123.6, 115.8, 112.0, 109.6, 105.6, 34.8, 32.0 ppm. - IR (ATR) 2951 (m), 1736 (s), 1568 (m), 1469 (m), 1429 (s), 1365 (s), 1307 (m), 1257 (m), 1227 (m), 1194 (m), 1162 (w), 1033 (w), 930 (w), 875 (w), 823 (w), 786 (m), 756 (m); 735 (m), 685 (w), 658 (w), 613 (w), 460 (w), 422 (vw) cm⁻¹. - FAB-MS (3-NBA) m/z (%): 538.3 [M⁺].

### Beispiel 6: N-phenothiazinenyl-diphenyl-phosphinoxid

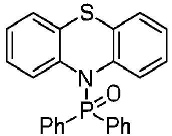

### Beispiel 7: N-phenoxazinenyl-diphenyl-phosphinoxid

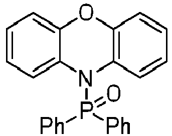

### Beispiel 8: Quantenmechanische Berechnungen

Zur Bestimmung der HOMO-/LUMO-Lagen wurden Dichtefunktionaltheorie-Rechnungen (DFT) unter Einsatz des BP86-Funktionals und der "resolution-of-identity"-Näherung sowie des def2-SV(P)-Basissatzes durchgeführt. Für die numerische Integration wurde das m4 grid verwendet.

### Beispiel 9: Cyclovoltammetrie

Cyclovoltammogramme von 10⁻³ molaren Lösungen der organischen Moleküle in Dichlormethan und Tetrabutylammoniumhexafluorophosphat (0.1 mol/l) als Leitelektrolyt wurden aufgenommen mit Hilfe eines Model 600D Series Electrochemical Analyzer mit Workstation (CH Instruments) bei einer Scanrate von 100 mV s⁻¹. Die Messungen wurden durchgeführt bei Raumtemperatur, unter Argon-Atmosphäre mit einer Dreielektroden-Anordnung (Arbeits- und Gegenelektrode: Pt-Wire. Referenzelektrode: Ag/AgCl) und kalibriert gegen FeCp₂/FeCp₂⁺ als internem Standard. HOMO- und LUMO-Daten wurden korrigiert mittels Ferrocen als internem Standard gegen SCE und nach folgenden Formeln berechnet (B. D'Andrade et al., Organic Electronics 2005, 6, 11.):
E_{CV-HOMO} = -(1.4 * 0.978 * (Ox/V - Ferrocen/V) + 4.6) eV
E_{CV-LUMO} = -(1.19 * (Red/V - Ferrocen/V) + 4.78) eV

### Beispiel 10: OLED-Bauteil A

OLED-Bauteil A wurde gemäß dem generellen Aufbau (Figur 1) hergestellt.

| | | |
|---|---|---|
| Kathode | Al | 100 nm |
| EIL | LiF | 1 nm |
| ETL | TPBi | 45 nm |
| EML | cylD25:omID154 | 30 nm |
| HTL | Poly-TPD | < 1 nm |
| HIL | V₂O₅ | 25 nm |
| Anode | ITO | 130 nm |

Ein Glassubstrat mit einer 130 nm dicken, strukturierten ITO-Schicht (Anode) wurde mit einer 25 nm dicken V₂O₅-Schicht als HIL an Luft beschichtet. V₂O₅ wurde hierbei aus einer 1:50 Vol%-Lösung aus Isopropanol und Vanadium(V)oxitriisopropoxid (Alfa Aesar) hergestellt (weitere Informationen Adv. Energy Mat. 2011, 1, 377).

Die nächsten Schichten der OLED wurden in einer Stickstoffbox hergestellt. Als HTL diente poly-TPD (American Dye Source, ADS254BE). Poly-TPD wurde in einer 4 mg/ml-Chlorbenzollösung bei einer Geschwindigkeit von 1000 U/min aufgeschleudert. Anschließend wurde die Schicht bei 110 °C ausgeheizt und im Folgenden zwei Mal mit Chlorbenzol gespült.

Als EML diente eine Mischung aus Emitter (cyID25) und Host (omID154). Diese wurde im Verhältnis 3:7 in einer 8 mg/ml-Toluollösung bei 2000 U/min aufgeschleudert. Die Schichtdicke beträgt 30 nm. Nachdem Aufschleudern wurde die Schicht bei 80 °C für 8 Minuten getrocknet.

Die abschließenden Schichten wurden thermisch im Vakuum aufgedampft. Als ETL wurden 45 nm TPBi (Sensient ST2175.S), als EIL 1 nm LiF (Carl Roth) und als Kathode 100 nm Al (Sigma Aldrich) aufgedampft.

Das OLED-Bauteil A wurde standardmäßig mit Hilfe eines Botestsytems charakterisiert. Aus der Leuchtdichte-Strom-Spannungsmessung und dem Elektrolumineszensspektrum wurden die externe Quanteneffizienz (EQE) zu 7,8 %, die Stromeffizienz (C_{eff}) zu 27 cd/A, und die Leistungseffizienz (P_{eff}) zu 21 Im/W berechnet.

### Beispiel 11: Synthese von Hostmolekülen

### •Di-heteroaryl-pyridine, DIHAPY

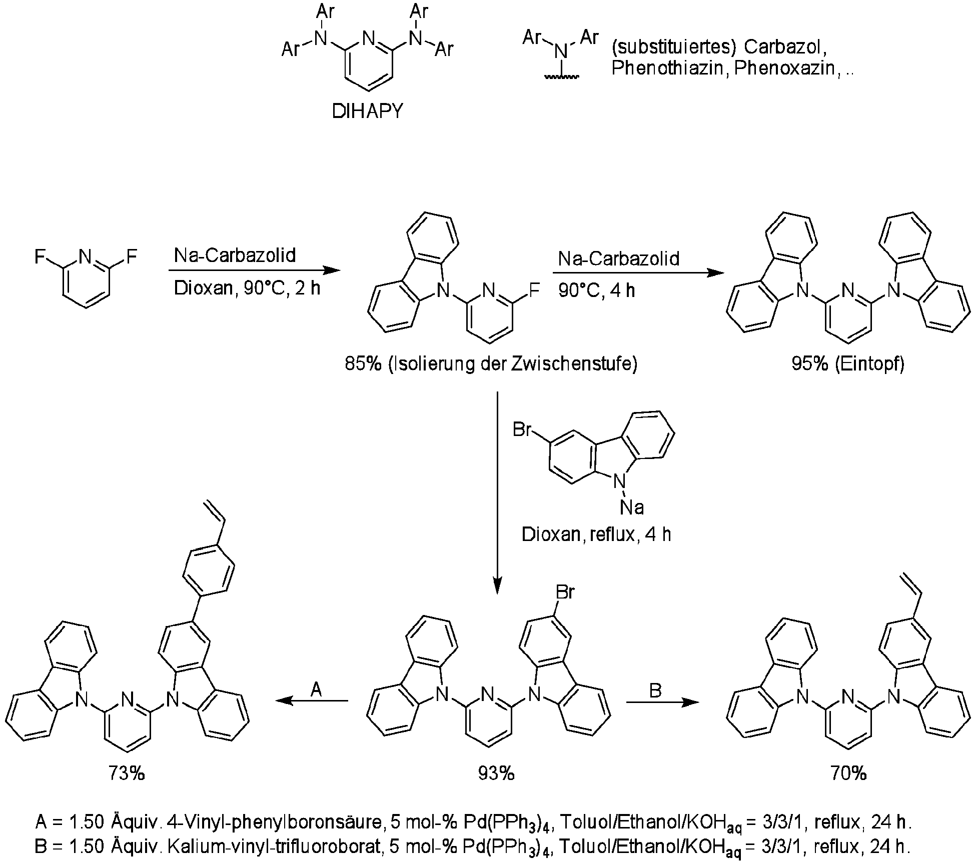

### Strukturen, Eigenschaften:

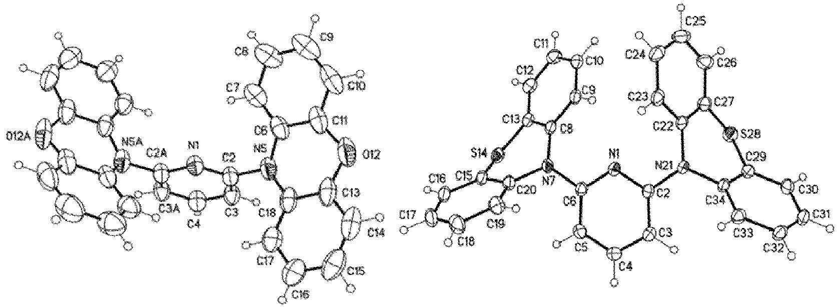

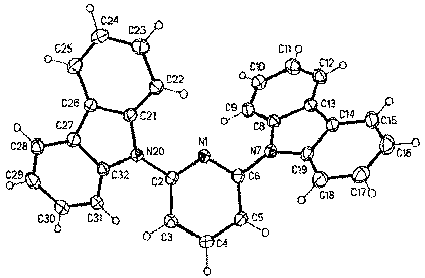

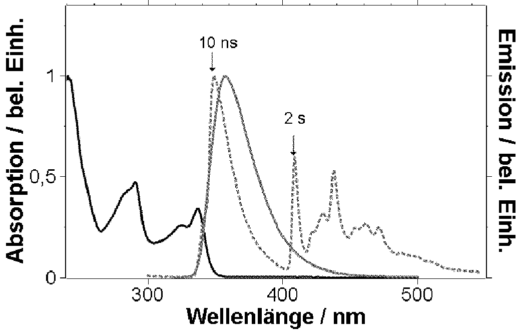

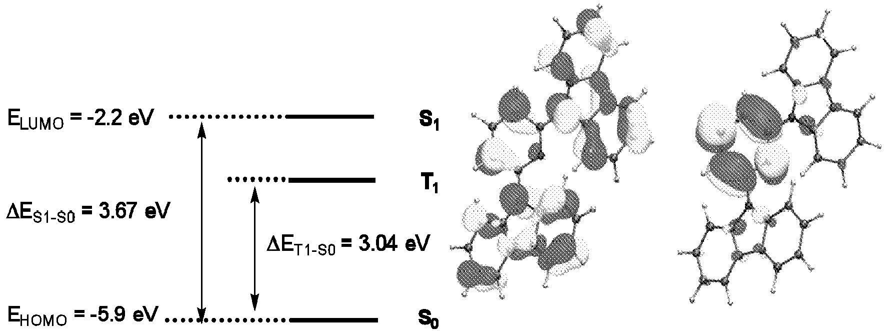

### Figuren

Es zeigen:
Figuren
   - Figur 1: schematisch den Aufbau einer OLED (Die Vorrichtung umfasst mindestens eine Anode, eine Kathode und eine Emitterschicht.);
   - Figur 2: Berechnete Grenzorbitale des Grundzustands von Beispiel 1.
   - Figur 3: Cyclovoltammogramm von Beispiel 1. Es finden ausschließlich reversible Prozesse statt.
   - Figur 4: Anregungs- und Emissionsspektrum eines Filmes von Beispiel 1 (pur gelöst in Toluol) (Anregung bei 250 nm).
   - Figur 5: Anregungs- und Emissionsspektrum eines Filmes von Beispiel 3 (pur gelöst in Toluol) (Anregung bei 320 nm).

## Patentansprüche

1. Organisches Molekül, aufweisend eine Struktur der Formel 1 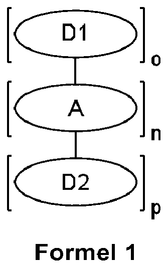 mit
A = eine Akzeptorgruppe mit elektronenziehenden Eigenschaften, unabhängig voneinander ausgewählt aus der Gruppe aus Pyridin, Triazin, Pyrimidin, P(=O)R¹₂, P(=O)R¹, P(=S)R¹₂, P(=S)R¹, P(=Se)R¹₂, P(=Se)R¹, Benzimidazol, 1,2,4-oxadiazol, 1,2,4-triazol, oder 1,2,3-Triazol;
wobei gilt
R¹ ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
R² ist bei jedem Auftreten gleich oder verschieden Wasserstoff, Deuterium, Alkyl- (linear, verzweigt oder zyklisch), Heteroalkyl-, Aryl-, Heteroaryl-, Alkenyl-, Alkinyl-Gruppen oder substituierte Alkyl- (linear, verzweigt oder zyklisch), Heteroalkyl-, Aryl-, Heteroaryl- und Alkenyl-Gruppen mit Substituenten wie Halogene oder Deuterium, Alkylgruppen (linear, verzweigt oder zyklisch);
und
D1 = eine Donorgruppe mit elektronenschiebenden Eigenschaften, aufweisend eine Struktur der Formel 1a; 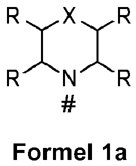 und
D2 = eine Donorgruppe mit elektronenschiebenden Eigenschaften, aufweisend eine Struktur der Formel 1b; 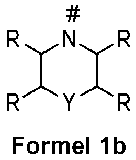 wobei für die verwendeten Symbole und Indizes gilt:
n ist eine ganze Zahl zwischen 0 und 5;
o ist eine ganze Zahl zwischen 1 und 5;
p eine ganze Zahl zwischen 0 und 5;
X ist gleich oder verschieden eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
Y ist bei jedem Auftreten gleich oder verschieden eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
R ist bei jedem Auftreten gleich oder verschieden Wasserstoff, Deuterium, Halogen, eine Alkylgruppe (linear, verzweigt oder zyklisch), eine Alkoxygruppe (auch verzweigt oder zyklisch), eine Alkenylgruppe (linear, verzweigt oder zyklisch), oder eine Aryl-oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme; dabei können zwei oder mehrere Substituenten R auch miteinander, zusammen mit den Atomen, an die sie gebunden sind, ein mono- oder polycylisches aliphatisches oder aromatisches Ringsystem bilden;
R³ ist bei jedem Auftreten gleich oder verschieden H, D, OR⁵, SR⁵ oder C(R⁵)₃;
R⁴ ist bei jedem Auftreten gleich oder verschieden H, D, OR⁵, SR⁵ oder C(R⁵)₃;
R⁵ ist bei jedem Auftreten gleich oder verschieden Wasserstoff, eine Alkylgruppe oder eine Arylgruppe;
und wobei die Verknüpfung mit A jeweils an der mit # gekennzeichneten Stelle in Form einer Einfachbindung stattfindet;

2. Organisches Molekül nach Anspruch 1, wobei D1 eine Struktur der Formel 2a und/oder D2 eine Struktur der Formel 2b aufweist; 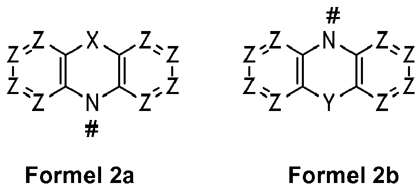 und wobei gilt:
Z ist bei jedem Auftreten gleich oder verschieden N oder CR⁴, wobei zwei oder mehrere Substituenten R⁴ auch miteinander, zusammen mit den Atomen, an die sie gebunden sind, ein mono- oder polycylisches aliphatisches oder aromatisches Ringsystem bilden können;
und die weiteren Symbole die in Anspruch 1 angegebenen Bedeutungen haben.

3. Verfahren zur Herstellung eines Organischen Moleküls nach Anspruch 1 oder 2, aufweisend den folgenden Schritt:
Durchführen einer Reaktion von A mit D1 oder von A mit D1 und D2,
wobei
mit
A = eine Akzeptorgruppe mit elektronenziehenden Eigenschaften;
D1 = eine Donorgruppe mit elektronenschiebenden Eigenschaften, aufweisend eine Struktur der Formel 1a; 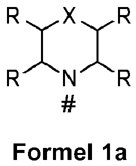 D2 = eine Donorgruppe mit elektronenschiebenden Eigenschaften, aufweisend eine Struktur der Formel 1b; 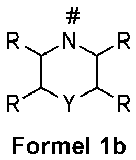 wobei die Verknüpfung mit A jeweils an der mit # gekennzeichneten Stelle in Form einer Einfachbindung stattfindet;
und wobei die weiteren Symbole die in Anspruch 1 angegebenen Bedeutungen haben.

4. Verfahren nach Anspruch 3, wobei die Reaktion unter Zugabe einer starken Base durchgeführt wird.

5. Verfahren nach Anspruch 3 oder 4, weiterhin aufweisend den Schritt der Zugabe eines Oxidationsmittels unabhängig voneinander ausgewählt aus der Gruppe bestehend aus Wasserstoffperoxid, Wasserstoffperoxid-Harnstoff-Addukt, Sauerstoff oder Ozon und optional weiterhin aufweisend den weiteren Schritt der Zugabe von Selen oder Schwefel oder Lawessons Reagenz.

6. Verwendung eines Organischen Moleküls nach Anspruch 1 oder 2 in einer emittierenden Schicht, bevorzugt als Matrixmaterial insbesondere für lumineszierende Emitter und/oder als Elektronentransportmaterial und/oder als Lochinjektionsmaterial und/oder als Lochblockiermaterial in einem optoelektronischen Bauelement.

7. Verwendung nach Anspruch 6, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

8. Optoelektronisches Bauelement, aufweisend ein Organisches Molekül nach Anspruch 1 oder 2.

9. Optoelektronisches Bauelement nach Anspruch 8, **dadurch gekennzeichnet, dass** das Organische Molekül nach Anspruch 1 oder 2 in einer emittierenden Schicht eingesetzt wird, bevorzugt als Matrixmaterial insbesondere für lumineszierende Emitter und/oder Elektronentransportmaterial und/oder als Lochinjektionsmaterial und/oder als Lochblockiermaterial.

10. Mischung, enthaltend mindestens ein organisches Molekül nach Anspruch 1 oder 2 und mindestens einen lumineszierenden Emitter.

11. Formulierung, enthaltend mindestens ein organisches Molekül nach Anspruch 1 oder 2 oder eine Mischung nach Anspruch 10 und mindestens ein Lösemittel.

12. Verfahren zur Herstellung eines optoelektronischen Bauelements, wobei ein Organisches Molekül nach Anspruch 1 oder 2 verwendet wird.

13. Verfahren nach Anspruch 12, **gekennzeichnet durch** das Aufbringen eines Organischen Moleküls nach Anspruch 1 oder 2 auf einen Träger.

14. Verfahren nach Anspruch 13, **dadurch gekennzeichnet, dass** das Aufbringen nass-chemisch erfolgt.

15. Verfahren nach Anspruch 13, **dadurch gekennzeichnet, dass** das Aufbringen durch Verdampfung im Vakuum erfolgt.
